(19) Europäisches Patentamt
European Patent Office
Office européen des brevets

(11) Publication number: 0 525 578 A1

# (12) EUROPEAN PATENT APPLICATION

(21) Application number: **92112403.8**

(22) Date of filing: **20.07.92**

(51) Int. Cl.5: **G03F 7/027**, G03C 9/08

(30) Priority: **02.08.91 US 739944**

(43) Date of publication of application:
**03.02.93 Bulletin 93/05**

(84) Designated Contracting States:
**CH DE FR GB IT LI NL**

(71) Applicant: **E.I. DU PONT DE NEMOURS AND COMPANY**
**1007 Market Street**
**Wilmington Delaware 19898(US)**

(72) Inventor: **Peiffer, Robert William**
**17 Hidden Valley Drive**
**Newark, Delaware 19711(US)**

(74) Representative: **Marsden, John Christopher et al**
**Frank B. Dehn & Co. Imperial House 15-19 Kingsway**
**London WC2B 6UZ(GB)**

## (54) Photopolymer composition for the production of three-dimensional objects.

(57) A process for forming a three-dimensional object comprises repeatedly imagewise exposing the surface of a reservoir of liquid photohardenable composition, curable by actinic radiation, with actinic radiation to harden the liquid composition near the surface to form a plurality of superimposed layers of hardened composition. In this invention, the liquid photohardenable composition consists essentially of:

(a) 25 to 65% of a difunctional acrylated polyurethane oligomer or a mixture of the oligomers;

(b) 15 to 65% of a polyglycol ester of the following formula:

$$H_2C=CR(CO)-O(CH_2-CH_2-O)_n-(CO)RC=CH_2$$

wherein:

R is hydrogen or methyl, and

n is an integer from 2 to 5;

or a mixture of the polyglycol esters;

(c) 0.1 to 10% of a photoinitiator system sensitive to the actinic radiation or a mixture of the photoinitiator systems; and

(d) 0 to 30% of a polyfunctional reactive diluent or a mixture of the reactive diluents;

wherein the liquid photohardenable composition has a viscosity of 200 to 8000 cP at 25° C.

EP 0 525 578 A1

## Field of the Invention

This invention pertains to the production of three-dimensional objects by photocuring. More particularly, this invention relates to photohardenable compositions for the production of clear, tough three-dimensional objects.

## Background of the Invention

In a rapidly evolving and highly competitive manufacturing environment, it is essential that the time required to generate new or redesigned parts be minimized. Increased use of computer-aided design has reduced design time, but production of a three-dimensional object, or model, from a design is still an expensive and time consuming process. Modifications of the original process are frequently required, and this iterative process can considerably lengthen the time necessary to develop and introduce a new or redesigned product.

To reduce the time and expense required to produce a three-dimensional object from an electronic design, a new technology, variously known as solid modeling, stereo-lithography, desktop manufacturing, steric polymerization, optical (photo)fabrication, stereo shaping, stereomolding, optical molding, and automatic molding, has been developed. Generally, the computer-generated three-dimensional design is sectioned into cross-sectional slices. Each slice is sequentially imaged on a layer of liquid photohardenable composition to build up the three-dimensional object. Imaging may be carried out with a computer-controlled scanning light source, such as a scanning optical fiber or a scanning laser, or by exposure through a series of masks.

Photohardenable compositions have been developed for use in the aforementioned solid modeling systems. These compositions typically contain one or more free radical polymerizable liquid ethylenically unsaturated monomers and/or oligomers plus a free radical initiator system sensitive to actinic radiation. Many of these compositions, such as those described in, for example, Krajewski, PCT Application WO 89/08021, in contain N-vinyl monomers, such as N-vinyl pyrrolidone. These monomers tend to produce objects which are brittle. Monomer toxicity is also a concern with these compositions, especially when they are used in office type environments.

There is a continuing need for photohardenable compositions which produce soft, flexible three-dimensional objects. Since flexible objects do not show the physical defects, i.e., stress induced cracking and distortion, frequently found in objects formed from compositions which produce brittle objects, larger parts can be produced. These compositions should also have a high sensitivity to actinic radiation, good aging characteristics, stable viscosity, low toxicity, and low shrinkage.

## Summary of the Invention

The present invention is a process for forming a three-dimensional object comprising repeatedly imagewise exposing the surface of a reservoir of liquid photohardenable composition, curable by actinic radiation, with actinic radiation to harden the liquid composition near the surface to form a plurality of superimposed layers of hardened composition. In this invention, the liquid photohardenable composition consists essentially of:

(a) 25 to 65% of a difunctional acrylated polyurethane oligomer or a mixture of the oligomers;

(b) 15 to 65% of a polyglycol ester of the following formula:

$$H_2C=CR(CO)\text{-}O(CH_2\text{-}CH_2\text{-}O)_n\text{-}(CO)RC=CH_2$$

wherein:

R is hydrogen or methyl, and

n is an integer from 2 to 5;

or a mixture of the polyglycol esters;

(c) 0.1 to 10% of a photoinitiator system sensitive to the actinic radiation or a mixture of the photoinitiator systems; and

(d) 0 to 30% of a polyfunctional reactive diluent or a mixture of the reactive diluents;

wherein the liquid photohardenable composition has a viscosity of 200 to 8000 cP at 25°C.

In a preferred embodiment of the invention, R is hydrogen. In a more preferred embodiment, n is 3 or 4. In a still more preferred embodiment, n is 4.

In another preferred embodiment, the composition consists essentially of 30-60% of oligomer, 20-50%

polyglycol ester, 1-8% photoinitiator, and 0-25% reactive diluent. In another more preferred embodiment, the composition consists essentially of 45-55% of oligomer, 25-40% polyglycol ester, 2-6% photoinitiator, and 10-20% reactive diluent. A viscosity of 300 to 3,000 cP is preferred.

## Detailed Description of the Preferred Embodiments

This invention is a process for forming three-dimensional objects. In this process the surface of a reservoir of liquid photohardenable composition curable by actinic radiation is repeatedly exposed to a beam of actinic radiation to harden the liquid composition near the surface. A plurality of superimposed layers of photohardened composition, which comprise the three-dimensional object, are formed. The excess unhardened liquid photohardenable composition is removed.

### Liquid Photohardenable Composition

The liquid photohardenable composition contains three components: a difunctional acrylated polyurethane oligomer, a polyglycol ester, and a photoinitiator system. An optional reactive diluent may also be present to control the viscosity of the composition.

### Acrylated Polyurethane Oligomers

"Acrylated polyurethane oligomer" refers to oligomers comprising acrylate and/or methacrylate functionality. An acrylated polyurethane oligomer is comprised of three moieties: an isocyanate derived moiety or moieties (designated by "I"), a backbone moiety ("B"), and an end-blocking moiety or moieties ("E"). In difunctional acrylated polyurethane oligomers, these moieties are arranged in the order:

E-I-B-I-E

Acrylated polyurethane oligomers can be prepared by the reaction of polyols with polyfunctional isocyanates. The isocyanate forms the isocyanate derived moiety of the oligomer. The polyol forms the backbone moiety. A stoichiometric excess of isocyanate groups relative to hydroxyl groups is present so that low molecular weight oligomers containing terminal isocycanate groups are produced. The terminal isocyanate groups react with hydroxyl containing photopolymerizable monomers to end-block the oligomer and form the end-blocking moieties. A discussion of acrylated polyurethane oligomers can be found in B. Martin, UV Curing: Science and Technology, Volume II, S. P Pappas, Ed., Technology Marketing Corp., Norwalk, CT, 1985, pp. 107-142.

Typically, a diisocyanate, such as, for example, toluene diisocyanate, isophorone diisocyanate, methylene bis(phenyl isocyanate), biscyclohexyl methyl diisocyanate, tetramethylene diisocyanate, or hexamethylene diisocyanate, is used.

To prepare difunctional acrylated polyurethane oligomers, the backbone is derived from a diol. Diols are polyether diols, such as, for example, polyethylene glycol, polypropylene glycol, copoly(ethylene oxide/propylene oxide), and poly(1,4-butanediol); and polyester diols, such as, for example, hexanediol adipate, butanediol adipate, neopentyl glycol adipate, ethylene glycol adipate, diethylene glycol adipate, polypropylene glycol adipate, 1,3-butylene glycol adipate and diethylene glycol adipate. Other typical diols include bisphenols, such as, for example, bis-phenol A.

Typical hydroxyl containing photopolymerizable monomers are, for example, hydroxyethyl acrylate, hydroxypropyl acrylate, hydroxyethyl methacrylate, butane monohydroxy monoacrylate, polypropylene glycol monoacrylate, and caprolactone monohydroxy monoacrylate. In the practice of this invention, acrylate monomers are preferred.

Anhydrides, such as, for example, phthalic anhydride, may also be included in the backbone, B. Two moles of polyol (represented by "P") are reacted with one mole of anhydride (represented by "A") to form a polyester diol (represented by PAP). Higher analogs (PAPAP, PAPAPAP, etc.) are also possible.

In the preferred acrylated polyurethane oligomers of this invention, the isocyanate is an aliphatic diisocyanate selected from the group consisting of: biscyclohexyl methyl diisocyanate, hexamethylene diisocyanate, tetramethylene diisocyanate, and isophorone diisocyanate. The backbone moiety of these materials is derived from a saturated polyester terminated with hydroxy groups selected from the group consisting of hexanediol adipate, butanediol adipate, neopentyl glycol adipate, ethylene glycol adipate, diethylene glycol adipate, polypropylene glycol adipate, and phthalic anhydride containing derivatives of these polyester diols. The oligomers are end-blocked with hydroxy acrylates selected from the group

consisting of hydroxypropyl acrylate, hydroxyethyl acrylate, butane monohydroxy monoacrylate, polypropylene glycol monoacrylate, caprolactone monohydroxy monoacrylate.

In the practice of this invention, mixtures of acrylated polyurethane oligomers may be used instead of a single acrylated polyurethane oligomer. Use of an oligomer mixture is considered to be equivalent to use of a single oligomer.

Polyglycol Ester

The polyglycol ester is an acrylate or methacrylate ester of the following structure:

$$H_2C=CR(CO)\text{-}O(CH_2\text{-}CH_2\text{-}O)_n\text{-}(CO)RC=CH_2$$

wherein:

R is hydrogen or methyl, and

n is an integer from 2 to 5.

Compositions in which R is hydrogen are preferred.

Compositions in which n is 3 or 4 are more preferred.

Compositions in which n is 4 are still more preferred.

In the practice of this invention, mixtures of polyglycol ester may be used instead of a single polyglycol ester. Use of a polyglycol ester mixture is considered to be equivalent to use of a single polyglycol ester.

Reactive Diluent

The composition may contain, as an optional ingredient, one or more reactive diluents. Reactive diluents are well known in the art. A discussion of reactive diluents can be found in R. S. Tu, UV Curing: Science and Technology, Volume II, S. P Pappas, Ed., Technology Marketing Corp., Norwalk, CT, 1985, pp. 144-246.

The reactive diluent may be added to control the viscosity of the composition so that it falls within the range of 200 to 8000 cP. The preferred viscosity range is selected based on the equipment used to form a fresh layer of unhardened composition contained in the reservoir. If a doctor blade is used, the preferred viscosity is in excess of 1000 cP. At these higher viscosities, the percentage of lower molecular weight reactive diluents can be minimized which yields images parts with less shrinkage and distortion. If a doctor blade is not used to form a fresh layer of unhardened composition, then the preferred viscosity range is from 200 to 1000 cP. These lower viscosities are required to allow the force of gravity to act on the composition to level the unhardened composition before exposure.

The reactive diluent may also be added to control the amount of cross-linking and, consequently, the flexibility or brittleness of the final object. The reactive diluent should be polyfunctional. That is, it should have at least two free radical polymerizable ethylenically unsaturated groups per molecule. The preferred reactive diluents have two (difunctional) or three (trifunctional) free radical polymerizable ethylenically unsaturated groups per molecule.

The reactive diluent should be relatively nonvolatile so it is not lost from the composition before and during formation of the three-dimensional object. Volatilization of the reactive diluent would change the properties of the photohardenable composition during formation of the object. The reactive diluent should be a material of relatively low toxicity. Because of the possibility of operator contact before, during, and after formation of the object, highly toxic materials should be avoided. It is especially important that the reactive diluent be essentially nonvolatile and relatively nontoxic when the photo-hardenable compositions are used in situations such as office type environments.

Useful reactive diluents include, for example: 1,3-propanediol diacrylate and dimethacrylate, 1,4-butanediol diacrylate and dimethacrylate, 1,5-pentanediol diacrylate and dimethacrylate, 1,6-hexanediol diacrylate and dimethacrylate, 1,7-heptanediol diacrylate and dimethacrylate, 1,8-octanediol diacrylate and dimethacrylate, trimethylolpropanetriol triacrylate and trimethacrylate, ethoxylated trimethylolpropanetriol triacrylate and trimethacrylate, neopentyl glycol diacrylate and dimethacrylate, tripropylene glycol diacrylate and dimethacrylate, pentaerythritol triacrylate and trimethacrylate, pentaerythritol tetraacrylate and tetramethacrylate, and the like.

The preferred reactive diluents are acrylates. More preferred reactive diluents are trimethylolpropane triol triacrylate, ethoxylated trimethylolpropane triol triacrylate, tripropylene glycol diacrylate, and 1,6-hexanediol diacrylate.

In the practice of this invention, mixtures of reactive diluents may be used instead of a single diluent.

Use of a diluent mixture is considered to be equivalent to use of a single diluent.

Photoinitiator System

The photoinitiator system comprises one or more compounds which directly furnish free-radicals when activated by actinic radiation. It can also comprise a plurality of compounds, one of which yields the free-radicals after having been caused to do so by another compound, or sensitizer, which has been activated by the radiation. "Actinic radiation" is radiation which is active to produce the radicals which initiate polymerization. For efficient formation of the three-dimensional object, most of the actinic radiation should be absorbed by the photoinitiator system.

Numerous conventional photoinitiator systems may be used to initiate polymerization provided they are compatible with the other ingredients of the composition; are sensitive to the actinic radiation used to form the object; produce dark stable compositions, i.e., compositions which do not harden in the absence of actinic radiation; and do not impart unwanted color to the final object. Discussions of initiator systems may be found, for example, in: V. D. McGinness, Phot. Sci. Eng. 23, 124, 1979; S. P. Pappas, in: UV Curing: Science and Technology, Volume II, S. P. Pappas, Ed., Technology Marketing Corporation, Norwalk, CT, 1985, pp 1-26; C. L. Osborn, J. Radiat. Curing, 3(3) 2, 1976; G. F. Vesley, J. Radiation Curing 13(1), 4, 1986, and A. Reiser, Photoreactive Polymers, Wiley-Interscience, New York, 1989, pp. 103-127.

For the production of clear, uncolored objects, photoinitiator systems which do not absorb substantial amounts of visible radiation, or which, on exposure, are converted to products which do not absorb substantial amounts of visible radiation are required. Preferred photoinitiator systems are initiators which undergo photofragmentation to form radicals, such as, for example, benzoin, benzoin methyl ether (BME), 2,2-dimethoxy-2-phenyl acetophenone (DMPA), 2,2-diethoxyacetophenone (DEAP), 1-benzoylcyclohexanol, and 2-methyl-1-[4-(methylthio)phenyl]-2-morpholinopropanone. The most preferred initiator is 2,2-dimethoxy-2-phenyl acetophenone (DMPA).

In the practice of this invention, mixtures of photoinitiator systems may be used instead of a single photoinitiator system. Use of a photoinitiator mixture is considered to be equivalent to use of a single photoinitiator.

Composition

The composition will contain sufficient difunctional acrylated polyurethane oligomer and sufficient polyester glycol to provide a clear, tough three-dimensional object. Sufficient photoinitiator will be present to initiate photopolymerization on exposure to actinic radiation. Sufficient reactive diluent may be added to control the viscosity of the composition.

The composition contains 25-65% of the difunctional acrylated polyurethane oligomer or a mixture of said oligomers, 15-65% of the polyglycol ester or a mixture of said polyglycol esters, 0.1-10% of the photoinitiator system or a mixture of said initiator systems, and 0-30% of the reactive diluents or mixture of said diluents. Preferably, the photohardenable composition contains 30-60% acrylated polyurethane oligomer, 20-50% polyglycol ester, 1-8% photoinitiator system, and 0-25% reactive diluent. More preferably, the composition contains 45-55% of acrylated polyurethane oligomer, 25-40% polyglycol ester, 2-6% photoinitiator system, and 10-20% reactive diluent.

Formation of Three Dimensional Objects

The process for the formation of three-dimensional objects is described in: H. Kodama, Rev. Sci. Instrum., 52, 1770 (1981); A. J. Herbert, J. Appl. Photo. Eng., 8, 185 (1982); Hull, U.S. Patent 4,575,330; Fudim, U.S. Patent 4,752,498; Grossa, U.S. Patent 4,942,060; Vassiliou, U.S. Patent 4,987,044; and Lawton, U.S. Patent 5,014,207. The teachings of these references are incorporated herein by reference.

In brief, a computer-generated three-dimensional design is prepared and cross-sectioned into slices using well known computer techniques. To build up the three-dimensional object, each slice is sequentially imaged on a layer of the liquid photohardenable composition contained in a reservoir. A support is positioned beneath the surface of the liquid photohardenable composition to hold the photohardened composition as it is formed. As each layer is formed, a fresh layer of unhardened composition is introduced, typically by lowering the support or raising the level of the reservoir. In the preferred embodiment of the instant invention, a portion of the composition from the reservoir, is raised above the surface level of the composition in the reservoir using an elongated dipper. The dipper, which has slots in its lower surface along its length, allows this portion of the composition it contains to drain through the slots and fall back into

the reservoir. When the dipper, filled with a portion of the composition, is translated in a direction normal to its length, the composition draining from the dipper is distributed over the surface of the reservoir, the platform surface, or the surface of a previously imaged layer. Immediately following the translating dipper is a doctor blade which translates with the dipper and smooths the deposited composition, that drained from the dipper over the surfaces.

Exposure is carried out with a computer-controlled scanning light source, such as a scanning optical fiber or a scanning laser. In the preferred embodiment of the instant invention, exposure is carried out, as described in US patent 5,014,207, in such a manner that provides substantially uniform control of exposure in the image plane. Effectively, with exposure control, the laser beam is modulated digitally corresponding to a discrete distance that the beam has moved in the image plane. Since the modulation of the laser beam calls for the laser beam to be on for a specific time frame per digital pulse, the result is a substantially more uniform exposure, and more uniform depth and width of photoformation, per distance moved by the laser beam in the image plane. However, it is not necessary to provide the exposure by use of a laser. The exposure could be made by, for example, light exposure through or reflected from an appropriate photomask, or, other radiative exposure methods, such as, for example, x-rays, microwave or radiofrequency wave excitation, and the like, assuming such radiation induces photoforming of the photoformable composition. Photomasks useful for the practice of this invention may be silver halide films (either transmitted through or backed by a mirror and reflected through), liquid crystal cells (reflective or transmissive), electrostatically deposited powders on a transparent web, ruticons, etc.

In the currently preferred embodiment of the instant invention, the laser used is a Coherent INNOVA® 326 with primary output in the UV having strong lines at 351 nm and 363 nm. The Coherent INNOVA® 326 also has the capability to produce a 333 nm wavelength output. However, to provide the best focusing in the current system, this wavelength is suppressed using optional laser optics provided commercially by Coherent. Typically, the beam spot has been focused to approximately 127 µm 1/e^2 diameter in the image plane. Larger or smaller spot diameters can be used but generally spot diameters in the range of 25 to 800 µm are preferred, and the range or 75 to 255 µm are most preferred since system costs of a smaller spot often outweigh the advantages of the higher resolution. The beam has a gaussian energy distribution. This type of distribution is preferred but other beam distributions, well known in the art may be used. The remainder of the focusing optics, scanning, and beam modulation is the same as that described in the referenced U.S. Patent 5,014,207.

It is currently preferred to scan the image as a series of parallel vector scans. Exposure of the composition can also be accomplished using other scanning methods, such as cross-hatching, weave, raster, etc. but this is not the preferred practice. The distance between the parallel vector scan lines is preferably 0.001". The scan lines can be closer or further apart and suitable results have been obtained in experiments using 0.001-0.003" scan line spacings.

Exposures have been given in the range of 7 mJ/cm^2, which yields a floating layer thickness of approximately 0.01 cm (4 mils), to 333 mJ/cm^2 which yields a floating layer thickness of approximately 0.078 cm (31 mils). The thickness versus exposure curve for the preferred composition may be adequately mathematically described using a logarithmic linear fit, but for the current usage in the present embodiment, a polynomial logarithmic fit is preferred. This curve is best generated for each individual piece of equipment due to variations in, for example, laser wavelength output and the like. A floating layer thickness is an analytical method for characterizing the compositions response to exposure and is not necessarily indicative of the compositions ability to form object layers. For example, object layers could conceivably be formed with greater thicknesses than 30 mils, if more exposure is given, but this is usually not preferred. Or object layers could be made with layer thicknesses less than 4 mils. The currently preferred operating range for this composition is 5 to 7 mil thick layers. Typically extra exposure is given to engage (attach) the imaged layer to the platform or to the previously imaged layer of the object. In the current operation, 4-5 mils of engagement is used for this purpose. Less engagement could be used with careful monitoring of the layer coating thickness, and naturally more engagement can be utilized but at the expense of object accuracy.

Typically the power of the beam that exposes the composition is around 200 mW. Greater or lesser spot powers could be used, as long as the proper wavelength and the necessary exposure is supplied for the object layer being formed.

When exposure is complete, the photoformed object is removed from the reservoir and the excess unhardened photohardenable composition removed. The excess composition can be allowed to drain away or it can removed by a solvent which does not substantially swell the photoformed object, such as, for example, 2-propanol. Combinations of these techniques may also be used.

Imaging exposure typically produces incomplete polymerization. Imaging is generally followed by a curing step in which the object is treated with heat and/or light to increase monomer conversion. Curing

increases the physical properties of the three-dimensional object and reduces the potential for operator contact with monomers in subsequent handling.

Industrial Applicability

The processes of this invention are useful for the production of three-dimensional objects from computer aided designs. These objects are useful as models of new or redesigned parts, particularly in the automotive and aerospace industries. In particular, the invention is useful for the production of clear, tough three-dimensional objects. Since the use of N-vinyl monomers, such as N-vinyl pyrrolidone, is avoided, the photohardenable compositions disclosed herein will be particularly useful in situations, such as office type environments, in which compositions of low toxicity are desired.

The advantageous properties of this invention can be observed by reference to the following examples which illustrate, but do not limit, the invention.

EXAMPLES

GLOSSARY

| | |
|---|---|
| DEGDA | SR-230; Diethylene glycol diacrylate; Sartomer Co., West Chester, PA |
| DMPA | Irgacure® 651; 2,2-Dimethoxy-2-phenyl acetophenone; Ciba-Geigy, Hawthorne,NY |
| Ebecryl 264 | 85% Aliphatic urethane triacrylate oligomer and 15% 1,6-hexanediol diacrylate; Radcure Specialties, Louisville, KY |
| Ebecryl 3604 | 80% Rubber modified epoxy acrylate oligomer, MW 1,195 and 20% tripropylene glycol diacrylate; Radcure Specialties, Louisville, KY |
| Ebecryl 3700 | Bis-phenol A epoxy diacrylate oligomer, MW 524; Radcure Specialties, Louisville, KY |
| HCPK | Irgacure® 184; 1-benzoylcyclohexanol; Ciba-Geigy, Hawthorne, NY |
| HDDA | SR-238; 1,6-Hexanediol diacrylate; CAS 13048-33-4; Sartomer Co., West Chester, PA |
| IBA | SR-506; Isobornyl acrylate; Sartomer Co., West Chester, PA |
| MPMP | Irgacure® 907; 2-Methyl-1-[4(methylthio)phenyl]-2-morpholinopropanone; Ciba-Geigy, Hawthorne, NY |
| NPGDA | SR-247; Neopentyl glycol diacrylate Sartomer Company, West Chester, PA |
| NVP | V-Pyrol/RC; N-Vinyl-2-pyrrolidone; GAF, Wayne, NJ |
| PEGDA | SR-344; Polyethylene glycol(400)diacrylate; CAS 26570-48-9; Sartomer Company, West Chester, PA |
| Photomer® 6008 | Aliphatic urethane acrylate oligomer, viscosity $2x10^6$ cP; reaction product of polypropylene glycol, toluene diioscyanate, and hydroxyethyl acrylate; Henkel Corp.,Morristown, NJ |
| POEA | SR-339; 2-Phenoxyethyl acrylate; CAS 48145-04-6; Sartomer Co., West Chester, PA |
| SR-454 | Ethoxylated trimethylolpropane triacrylate; Sartomer Co., West Chester, PA |
| SR-9604 | About 75% aliphatic urethane acrylate, viscosity $2x10^6$ cP at 40°C; about 24% ethoxylated trimethylolpropane triacrylate, CAS 28961-43-5, and about 1% other esters; Sartomer Co., West Chester, PA |
| SR-9634 | About 75% aliphatic urethane acrylate, viscosity $1.6x10^6$ cP at 40°C; about 24% ethoxylated trimethylolpropane triacrylate, CAS 28961-43-5, and about 1% other esters; Sartomer Co., West Chester, PA |
| TEGDA | SR-272; Triethylene glycol diacrylate; Sartomer Co., West Chester, PA |
| THFA | SR-285; Tetrhydrofurfuryl acrylate,CAS 2399-48-6; Sartomer Co., West Chester, PA |
| TTEGADA | Tetraethylene glycol diacrylate; Radcure Specialties, Louisville, KY |

Evaluation Procedure

Photohardenable compositions were prepared by mixing the indicated ingredients. The viscosity of each composition was measured with a Brookfield Model DV-II viscometer at ambient temperatures (ca. 20-25°C).

Evaluations were carried out in the SOMOS™ Solid Imaging Apparatus. This apparatus fabricates a

three-dimensional object by selectively exposing successive layers of a liquid composition with actinic radiation.

In brief, the apparatus comprises a vessel for containing a reservoir of photohardenable composition so as to present a free surface and a movable platform disposed within the vessel below the free surface. Part of the composition is transferred above the free surface by lowering and raising a dispenser at predetermined positions located away from the platform. A doctor blade contacts the composition transferred above the free surface, and then moves over the platform to form a substantially uniform layer of the composition.

The composition was exposed with a Coherent Innova® 306 argon ion laser. The wavelength output of the laser used in this case had major lines at 333 nm (15-20% of the power) and at 351 and 363 nm (with the remainder of the power distributed between these lines). The power in the beam spot typically ranged from 150 mW to 240 mW. The exposure system is described in Lawton, U.S. Patent 5,014,207 and is substantially the same as above.

A series of three-dimensional objects was prepared and evaluated for each composition. Free floating "step wedges", consisting of six squares approximately 1.2 cm on a side, were prepared by exposing each composition at six different exposure energies. This range of energies typically ranged from 5.6 $mJ/cm^2$ to 256.8 $mJ/cm^2$. The squares were removed from the vessel containing the reservoir of photohardenable composition, quickly cleaned with 2-propanol, and dried. The thickness of each square was measured and a plot of thickness versus $\log_e$ of exposure energy prepared. The composition which exhibited the largest slope and highest thickness intercept was assigned a relative photospeed of 1. The remaining compositions were assigned values based on the decreasing value of the slope and intercept. The physical integrity of each object was judged by examination.

Following exposure and cleaning, the imaged objects were cured by exposure with a high pressure mercury vapor lamp. Alternatively, unimaged samples of the compositions were cured in Petri dishes with the same high pressure mercury vapor lamp to obtain cured disks. The physical integrity of each cured object was judged by examination. Volumetric shrinkage on polymerization was estimated by comparison of the specific gravity of the uncured and cured objects with the specific gravity of the corresponding unexposed photohardenable composition. The uncorrected difference was used to estimate volumetric shrinkage.

Control Examples A-B

These examples illustrate that brittle solid objects are formed from photohardenable compositions containing N-vinyl-2-pyrrolidone (NVP).

The compositions described in Table 1 were prepared and evaluated as described above. The physical properties of the resulting solid objects are given in Table 2.

Table 1

| Ingredient[a] | A | B | C |
|---|---|---|---|
| SR-3904 | 38.7 | - | - |
| Photomer\ 6008 | - | 64.5 | - |
| SR-9634 | - | - | 64.5 |
| TTEGDA | 47.3 | 21.5 | - |
| NVP | 10.8 | 10.8 | 32.3 |
| DMPA | 3.2 | 3.2 | 3.2 |

[a]Amounts in percent.

Table 2

| Property | A | B | C[a] |
|---|---|---|---|
| Viscosity (cP) | 1,020 | 2,700 | 384 |
| Photospeed[b] | 2 | 1 | 1 |
| Physical Integrity of Uncured Object | Good | Good | Good |
| Physical Integrity of Cured Object | Hard Brittle | Hard Brittle | Brittle |

[a]Volumetric shrinkage for uncured object, 9.1%; for cured object, 13.3%.
[b]Relative photospeed (1 fastest to 5 slowest).

Control Examples D-I

These examples illustrate photohardenable compositions which do not contain a polyglycol ester in which n is 2-5.

The compositions described in Table 3 and 4 were prepared and evaluated as described above. The physical properties of the resulting solid objects and the volumetric shrinkage for the uncured and cured objects are given in Table 5 and 6.

Table 3

| Ingredient[a] | D | E | F |
|---|---|---|---|
| SR-9634 | 64.5 | 64.5 | 64.5 |
| PEGDA | 32.3 | - | - |
| NPGDA | - | 32.3 | - |
| HDDA | - | - | 32.3 |
| DMPA | 3.2 | 3.2 | 3.2 |

[a]Amounts in percent.

Table 4

| Ingredient[a] | G | H | I |
|---|---|---|---|
| SR-9634 | 64.5 | 64.5 | 64.5 |
| POEA | 32.3 | - | - |
| THFA | - | 32.3 | - |
| IBA | - | - | 32.3 |
| DMPA | 3.2 | 3.2 | 3.2 |

[a]Amounts in percent.

Table 5

| Property | D | E | F |
|---|---|---|---|
| Viscosity (cP) | 3,220 | 1,890 | 888 |
| Photospeed[a] | 4 | 9 | 7 |
| Physical Integrity of Uncured Object | Poor | Poor | Poor |
| Physical Integrity of Cured Object | Fair Flexible | Brittle | Fair Flexible |
| Volumetric Shrinkage -Uncured Object | 4.5% | 6.4% | 12.5% |
| Volumetric Shrinkage -Cured Object | 5.6% | 11.8% | 12.3% |

[a]Relative photospeed (1 fastest to 10 slowest).

Table 6

| Property | G | H | I |
|---|---|---|---|
| Viscosity (cP) | 574 | 2,250 | 384 |
| Photospeed[a] | 10 | 8 | 1 |
| Physical Integrity of Uncured Object | Poor | Poor | Poor |
| Physical Integrity of Cured Object | Fair Flexible | Brittle | Brittle |
| Volumetric Shrinkage -Uncured Object | 12.5% | 11.9% | 9.1% |
| Volumetric Shrinkage -Cured Object | 12.5% | 7.1% | 13.3% |

[a]Relative photospeed (1 fastest to 10 slowest).

Control Example J

This example illustrates a photohardenable composition which comprises polyethylene glycol diacrylate.

A composition containing SR-9406 (38.7%), PEGDA (58.1%) and DMPA (3.2%) was evaluated as described above. The viscosity of the composition was 1,570 cP. Relative photospeed (1 fastest to 5 slowest) was 5. The physical integrity of both the uncured and cured samples was poor.

Examples 1-3

These examples illustrate photohardenable compositions of this invention in which the compositions contain different polyglycol esters.

The compositions described in Table 7 were prepared and evaluated as described above. The physical properties of the resulting solid objects and the volumetric shrinkage for the uncured and cured objects are given in Table 8.

Table 7

| Ingredient[a] | 1 | 2 | 3 |
|---|---|---|---|
| SR-9634 | 64.5 | 64.5 | 64.5 |
| DEGDA | 32.3 | - | - |
| TEGDA | - | 32.3 | - |
| TTEGDA | - | - | 32.3 |
| DMPA | 3.2 | 3.2 | 3.2 |

[a]Amounts in percent.

Table 8

| Property | 1 | 2 | 3 |
|---|---|---|---|
| Viscosity (cP) | 1,240 | 1,390 | 1,720 |
| Photospeed[a] | 5 | 3 | 2 |
| Physical Integrity of Uncured Object | Good | Good | Good |
| Physical Integrity of Cured Object | Tough | Tough | Tough |
| Volumetric Shrinkage -Uncured Object | 5.3% | 7.2% | 4.5% |
| Volumetric Shrinkage - Cured Object | 6.1% | 11.2% | 4.4% |

[a]Relative photospeed (1 fastest to 5 slowest)

Examples 4-6

These examples illustrate photohardenable compositions of this invention in which different difunctional acrylated polyurethane oligomers are present in the compositions.

The compositions described in Tables 9 and 10 were prepared and evaluated as described above. The physical properties of the resulting solid objects and the volumetric shrinkage for the uncured and cured objects are given in Tables 11 and 12.

Table 9

| Ingredient[a] | 4 | 5 | 6 |
|---|---|---|---|
| SR-9634 | 48.8 | - | - |
| Ebecryl 264 | - | 48.8 | - |
| Ebecryl 3700 | - | - | 48.8 |
| TTEGDA | 48.8 | 48.8 | 48.8 |
| DMPA | 2.4 | 2.4 | 2.4 |

[a]Amounts in percent.

Table 10

| Ingredient[a] | 7 | 8 | 9 |
|---|---|---|---|
| Ebecryl 3604 | 48.8 | - | - |
| Photomer® 6008 | - | 64.5 | - |
| SR-9604 | - | - | 38.7 |
| TTEGDA | 48.8 | 32.3 | 58.1 |
| DMPA | 2.4 | 3.2 | 3.2 |

[a]Amounts in percent.

Table 11

| Property | 4 | 5 | 6 |
|---|---|---|---|
| Viscosity (cP) | 341 | 466 | 316 |
| Photospeed[a] | 2 | 5 | 1 |
| Physical Integrity of Uncured Object | Fair | Poor | Good |
| Physical Integrity of Cured Object | Tough | Tough | Tough |

[a]Relative photospeed (1 fastest to 5 slowest)

Table 12

| Property | 7 | 8 | 9 |
|---|---|---|---|
| Viscosity (cP) | 1,330 | 3,390 | 1,160 |
| Photospeed[a] | 4 | 3 | 4 |
| Physical Integrity of Uncured Object | Poor | Fair | Good |
| Physical Integrity of Cured Object | Tough | Tough Flexible | Tough, Flexible |

[a]Relative photospeed (1 fastest to 5 slowest)

Examples 10-13

These examples illustrate photohardenable compositions of this invention in which the compositions contain different photoinitiators.

The compositions described in Table 13 were prepared and evaluated as described above. The physical properties of the resulting uncured and cured solid objects are given in Table 14.

Table 13

| Ingredient[a] | 10 | 11 | 12 | 13 |
|---|---|---|---|---|
| Photomer® 6008 | 62.5 | 64.5 | - | - |
| TTEGDA | 31.2 | 32.3 | 32.3 | 32.3 |
| SR-9634 | - | - | 64.5 | 64.5 |
| HCPK | 6.3 | - | - | - |
| DMPA | - | 3.2 | - | 3.2 |
| MPMP | - | - | 3.2 | - |

[a]Amounts in percent.

Table 14

| Property | 10 | 11 | 12 | 13 |
|---|---|---|---|---|
| Viscosity (cP) | 3,740 | 4,240 | 1,970 | 1,360 |
| Photospeed[a] | 1 | 2 | 4 | 3 |
| Physical Integrity of Uncured Object | Good | Good | Good | Good |
| Physical Integrity of Cured Object | Tough, Flexible Slightly Brittle | Tough, Flexible | Tough, Flexible | Tough, Flexible |

[a]Relative photospeed (1 fastest to 5 slowest)

Having described the invention, we now claim the following and their equivalents.

**Claims**

1. In a process for forming a three-dimensional object including repeatedly imagewise exposing the surface of a reservoir of liquid photohardenable composition curable by actinic radiation with said actinic radiation to harden said liquid composition near said surface to form a plurality of superimposed layers of hardened composition, the improvement comprising:
   said liquid photohardenable composition consisting essentially of:
   (a) 25 to 65% of a difunctional acrylated polyurethane oligomer or a mixture of said oligomers;
   (b) 15 to 65% of a polyglycol ester of the following formula:

   $$H_2C=CR(CO)\text{-}O(CH_2\text{-}CH_2\text{-}O)_n\text{-}(CO)RC=CH_2$$

   wherein:
   R is hydrogen or methyl, and
   n is an integer from 2 to 5;
   or a mixture of said polyglycol esters;
   (c) 0.1 to 10% of a photoinitiator system sensitive to said actinic radiation or a mixture of said photoinitiator systems; and
   (d) 0 to 30% of a polyfunctional reactive diluent or a mixture of said reactive diluents;
   wherein said liquid photohardenable composition has a viscosity of 200 to 8000 cP at 25 °C.

2. The process of claim 1 wherein said acrylated polyurethane oligomer is an acrylate.

3. The process of claim 2 wherein R is hydrogen.

**4.** The process of claim 3 wherein said reactive diluent is an acrylate.

**5.** The process of claim 4 wherein said photohardenable consists essentially of 30-60% acrylated polyurethane oligomer (a), 20-50% polyglycol ester (b), 1-8% photoinitiator system (c), and 0-25% reactive diluent (d).

**6.** The process of claim 5 wherein n is 3 or 4.

**7.** The process of claim 6 wherein said photohardenable composition consists essentially of 45-55% of acrylated polyurethane oligomer (a), 25-40% polyglycol ester (b), 2-6% photoinitiator system (c), and 10-20% reactive diluent (d).

**8.** The process of claim 7 wherein said viscosity is 300-3,000 cP.

**9.** The process of claim 8 wherein said reactive diluent is selected from the group consisting of trimethylolpropane triol triacrylate, ethoxylated trimethylolpropane triol triacrylate, tripropylene glycol diacrylate, and 1,6-hexanediol diacrylate.

**10.** The process of claim 9 wherein n is 4.

**11.** The process of claim 4 wherein said difunctional acrylated polyurethane oligomer is represented by:

E-I-B-I-B

wherein:

said end-blocking moiety, E, is derived a hydroxy acrylate selected from the group consisting of hydroxypropyl acrylate, hydroxyethyl acrylate, butane monohydroxy monoacrylate, polypropylene glycol monoacrylate, caprolactone monohydroxy monoacrylate;

said isocyanate derived moiety, I, is derived from a diisocyanate selected from the group consisting of biscyclohexyl methyl diisocyanate, hexamethylene diisocyanate, tetramethylene diisocyanate, and isophorone diisocyanate; and

said backbone moiety, B, is derived from a saturated polyester terminated with hydroxy groups selected from the group consisting of hexanediol adipate, butanediol adipate, neopentyl glycol adipate, ethylene glycol adipate, diethylene glycol adipate, polypropylene glycol adipate, and phthalic anhydride containing derivatives of these polyester diols.

**12.** The process of claim 11 wherein said photohardenable composition consists essentially of 30-60% acrylated polyurethane oligomer (a), 20-50% polyglycol ester (b), 1-8% photoinitiator system (c), and 0-25% reactive diluent (d).

**13.** The process of claim 12 wherein n is 3 or 4.

**14.** The process of claim 13 wherein said photohardenable composition consists essentially of 45-55% of acrylated polyurethane oligomer (a), 25-40% polyglycol ester (b), 2-6% photoinitiator system (c), and 10-20% reactive diluent (d).

**15.** The process of claim 14 wherein said viscosity is 300-3,000 cP.

**16.** The process of claim 15 wherein said reactive diluent is selected from the group consisting of trimethylolpropane triol triacrylate, ethoxylated trimethylolpropane triol triacrylate, tripropylene glycol diacrylate, and 1,6-hexanediol diacrylate.

**17.** The process of claim 16 wherein n is 4.

**18.** The process of claim 17 wherein said reactive diluent is ethoxylated trimethylol propane triacrylate.

**19.** The process of claim 18 wherein said photoinitiator system is 2,2-dimethoxy-2-phenyl acetophenone.

**20.** An improved three-dimensional object prepared by repeatedly imagewise exposing the surface of a reservoir of liquid photohardenable composition curable by actinic radiation with said actinic radiation to harden said liquid composition near said surface to form a plurality of superimposed layers of hardened composition and removing unhardened liquid composition, wherein the improvement comprises:

said liquid photohardenable composition consisting essentially of:

(a) 25 to 65% of a difunctional acrylated polyurethane oligomer or a mixture of said oligomers;

(b) 15 to 65% of a polyglycol ester of the following formula:

$$H_2C=CR(CO)\text{-}O(CH_2\text{-}CH_2\text{-}O)_n\text{-}(CO)RC=CH_2$$

wherein:

R is hydrogen or methyl, and

n is an integer from 2 to 5,

or a mixture of said polyglycol esters;

(c) 0.1 to 10% of a photoinitiator system sensitive to said actinic radiation or a mixture of said photoinitiator systems; and

(d) 0 to 30% of a polyfunctional reactive diluent or a mixture of said reactive diluents; wherein said liquid photohardenable composition has a viscosity of 200 to 8000 cP at 25 °C.

**21.** The object of claim 20 wherein said acrylated polyurethane oligomer is an acrylate.

**22.** The object of claim 21 wherein R is hydrogen.

**23.** The object of claim 22 wherein said reactive diluent is an acrylate.

**24.** The object of claim 23 wherein said photohardenable composition consists essentially of 30-60% acrylated polyurethane oligomer (a), 20-50% polyglycol ester (b), 1-8% photoinitiator system (c), and 0-25% reactive diluent (d).

**25.** The object of claim 24 wherein n is 3 or 4.

**26.** The object of claim 25 wherein said photohardenable composition consists essentially of 45-55% of acrylated polyurethane oligomer (a), 25-40% polyglycol ester (b), 2-6% photoinitiator system (c), and 10-20% reactive diluent (d).

**27.** The object of claim 26 wherein said viscosity is 300-3,000 cP.

**28.** The object of claim 27 wherein said reactive diluent is selected from the group consisting of trimethylolpropane triol triacrylate, ethoxylated trimethylolpropane triol triacrylate, tripropylene glycol diacrylate, and 1,6-hexanediol diacrylate.

**29.** The object of claim 28 wherein n is 4.

**30.** The object of claim 23 wherein said difunctional acrylated polyurethane oligomer is represented by:

E-I-B-I-B

wherein:

said end-blocking moiety, E, is derived a hydroxy acrylate selected from the group consisting of hydroxypropyl acrylate, hydroxyethyl acrylate, butane monohydroxy monoacrylate, polypropylene glycol monoacrylate, caprolactone monohydroxy monoacrylate;

said isocyanate derived moiety, I, is derived from a diisocyanate selected from the group consisting of biscyclohexyl methyl diisocyanate, hexamethylene diisocyanate, tetramethylene diisocyanate, and isophorone diisocyanate; and

said backbone moiety, B, is derived from a saturated polyester terminated with hydroxy groups selected from the group consisting of hexanediol adipate, butanediol adipate, neopentyl glycol adipate, ethylene glycol adipate, diethylene glycol adipate, polypropylene glycol adipate, and phthalic anhydride containing derivatives of these polyester diols.

**31.** The object of claim 30 wherein said photohardenable consists essentially of 30-60% acrylated polyurethane oligomer (a), 20-50% polyglycol ester (b), 1-8% photoinitiator system (c), and 0-25% reactive diluent (d).

**32.** The object of claim 31 wherein n is 3 or 4.

**33.** The object of claim 32 wherein said photohardenable composition consists essentially of 45-55% of acrylated polyurethane oligomer (a), 25-40% polyglycol ester (b), 2-6% photoinitiator system (c), and 10-20% reactive diluent (d).

**34.** The object of claim 33 wherein said viscosity is 300-3,000 cP.

**35.** The object of claim 34 wherein said reactive diluent is selected from the group consisting of trimethylolpropane triol triacrylate, ethoxylated trimethylolpropane triol triacrylate, tripropylene glycol diacrylate, and 1,6-hexanediol diacrylate.

**36.** The object of claim 35 wherein n is 4.

**37.** The object of claim 36 wherein said reactive diluent is ethoxylated trimethylol propane triacrylate.

**38.** The object of claim 37 wherein said photoinitiator system is 2,2-dimethoxy-2-phenyl acetophenone.

European Patent Office

# EUROPEAN SEARCH REPORT

Application Number

EP 92 11 2403

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | EP-A-0 425 441 (CIBA-GEIGY AG)<br>* page 3, line 27 - line 29 *<br>* page 4, line 23 - line 25 *<br>* page 4, line 45 - line 48 *<br>* page 5, line 9 *<br>* page 6, line 22 - line 23 *<br>* claim 10 *<br>----- | 1-38 | G03F7/027<br>G03C9/08 |
| | | | **TECHNICAL FIELDS SEARCHED (Int. Cl.5 )** |
| | | | G03F<br>G03C |

The present search report has been drawn up for all claims

| Place of search | Date of completion of the search | Examiner |
|---|---|---|
| THE HAGUE | 21 OCTOBER 1992 | DUPART J-M.B. |

**CATEGORY OF CITED DOCUMENTS**

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)